# EUROPEAN PATENT SPECIFICATION

(11) **EP 1 070 370 B1**
(45) Date of publication and mention of the grant of the patent: **05.03.2003**
(21) Application number: 98900925.3
(22) Date of filing: 20.01.1998
(51) Int. Cl.: H01S 5/40, H01S 3/0941

(54) **Laser assembly for pumping optical amplifiers**
Laseranordnung zum Pumpen von optischen Verstärkern
Ensemble laser pour pomper des amplificateurs optiques

(43) Date of publication of application: 24.01.2001
(73) Proprietor: Nortel Networks Limited, Montreal, Quebec H2Y 3Y4 (CA)
(72) Inventor: EPWORTH, Richard, Edward, Sawbridgeworth Herts CM21 0BD (GB); KING, Jonathan, Paul, Essex CM16 5AU (GB)
(74) Representative: Anderson, Angela
(86) International application number: GB9800171
(87) International publication number: WO99037002

(56) References cited:
- EP-A- 0 704 949
- ZIRNGIBL M ET AL: "AN 18-CHANNEL MULTIFREQUENCY LASER" IEEE PHOTONICS TECHNOLOGY LETTERS, vol. 8, no. 7, 1 July 1996, pages 870-872, XP000595606
- GILES C R ET AL: "SIMULTANEOUS WAVELENGTH-STABILIZATION OF 980-NM PUMP LASERS" IEEE PHOTONICS TECHNOLOGY LETTERS, vol. 6, no. 8, 1 August 1994, pages 907-909, XP000465479
- PATENT ABSTRACTS OF JAPAN vol. 012, no. 095 (P-681), 29 March 1988 & JP 62 229105 A (NIPPON TELEGR & TELEPH CORP), 7 October 1987
- TACHIKAWA Y ET AL: "32 WAVELENGHT TUNABLE ARRAYED-WAVEGUIDE GRATING LASER BASED ON SPECIAL INPUT/OUTPUT ARRANGEMENT" ELECTRONICS LETTERS, vol. 31, no. 19, 14 September 1995, page 1665/1666 XP000530386
- DIANOV E M ET AL: "INJECTION LASER WITH INTEGRATED MACH-ZEHNDER CAVITY" PROCEEDINGS OF THE EUROPEAN CONFERENCE ON OPTICAL COMMUNICATION (EC REGULAR PAPERS, BERLIN, SEPT. 27 - OCT. 1, 1992 BOUND AS ONE WITH VOLUMES 2 & 3, vol. 1, no. CONF. 18, 27 September 1992, pages 189-192, XP000628135 INFORMATIONSTECHNISCHE GESELLSCHAFT IM VDE

## Description

### Background to the Invention

This invention relates to laser assemblies with common outputs. A particular though not necessarily exclusive application for such devices is for optically pumping optical amplifiers.

In the field of optically pumped optical amplifiers the optical wavelength multiplexing of pump sources has been proposed as a way of increasing pump power in a single spatial mode. All the different pump wavelengths need to be confined within the appropriate absorption spectrum of the optical amplifier, and also involves the emission wavelength of the individual pumps being spectrally aligned with the spectral characteristics of the wavelength multiplexer. Typically this requires active wavelength control using feedback electro-optic control loops to achieve the requisite spectral precision. Such feedback is for instance employed in the wavelength multiplexed optical amplifier pump described in UK Patent Application GB 2 293 684.

It is known from both "An 18-Channel Multifrequency Laser", Zirngibl M et al, IEEE Phot. Techn. Lett., Vol. 8, no. 7, 1 July 1996, p. 870-872 and Patent Abstracts of Japan, vol, 012, no. 095 (P-681), 29 March 1988 and JP 62 229105 A (Nippon Telegr & Teleph Corp), 7 October 1987, to provide a laser assembly having a set of N reflectors optically coupled via a set of N optical amplifiers and an Nx1 wavelength multiplexer with a partially reflecting common reflector so as to define N laser cavities providing an N-way wavelength-multiplexed output from the common reflector.

### Summary of the Invention

The present invention is directed to an alternative way of obtaining the requisite spectral precision that is advantageous in that it is all-optical rather than electro-optical.

According to an aspect of the present invention there is a provided a laser assembly having a set of N reflectors optically coupled via a set of N optical amplifiers and an Nx1 wavelength multiplexer with a partially reflecting common reflector so as to define N laser cavities providing an N-way wavelength-multiplexed output from the common reflector, which is characterised in that the Nx1 wavelength multiplexer comprises at least one Mach-Zehnder waveguide scheme.

Preferably the N optical amplifiers are semiconductor chips each provided with an antireflection coated facet at one end of the chip and a reflecting facet at the other. A feature of the invention is that multiple wavelength operation is possible without the imposition of the requirement that each of the N chips be different from each of the other N-1 chips. They may be all identical, and can be constructed in monolithic form.

It is also an object of the present invention to provide, for an optical transmission system, an optically pumped optical amplifier in which increased pump power is provided by wavelength multiplexing into a single optical mode a plurality of closely wavelength spaced optical sources in a manner that avoids the need either for tight wavelength tolerancing of the individual sources, or for active electro-optical feedback wavelength control of these sources.

In another aspect, the invention also provides an optical amplifier optically pumped by a laser assembly having a set of N reflectors optically coupled via a set of N optical amplifiers and an Nx1 wavelength multiplexer with a partially reflecting common reflector so as to define N laser cavities providing an N-way wavelength-multiplexed output from the common reflector, characterised in that the Nx1 wavelength multiplexer comprises at least one Mach-Zehnder waveguide structure.

In yet another aspect, the invention provides a method of controlling the wavelength relationship between the emission wavelengths of a set of N lasing optical pump sources in an optically pumped optical amplifier provided with feedback to make the optical pump sources lase, the method comprising providing the feedback in part by a partial reflector that is common to all the lasing sources via an Nx1 wavelength multiplexing element to provide a combined wavelength multiplexed optical pump output from the partial reflector, wherein the Nx1 wavelength multiplexer comprises at least one Mach-Zehnder waveguide structure.

### Brief Description of the Drawings

There follows a description of laser assemblies embodying the invention in preferred forms. The description refers to the accompanying drawings in which:-
- Figure 1: depicts a schematic diagram of a laser assembly constituting the pump of an optically pumped fibre amplifier,
- Figure 2: schematically depicts an embodiment of the laser assembly of Figure 1 employing a single Mach Zehnder as its wavelength multiplexer,
- Figure 3: depicts a preferred arrangement of wavelength dependencies for the laser assembly of Figure 2, and
- Figure 4: schematically depicts an embodiment of the laser assembly of Figure 1 employing a tree of three Mach-Zehnders as its wavelength multiplexer.

### Detailed Description of Preferred Embodiments

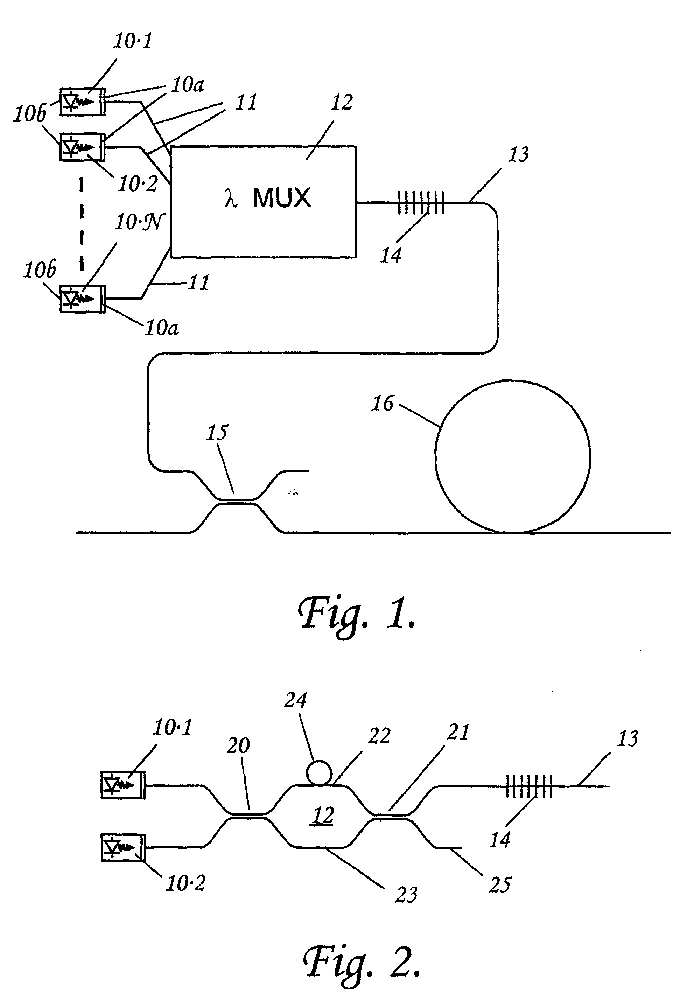

Referring to Figure 1, set of N semiconductor injection optical amplifier chips 10·1, 10·2 ... 10·N are each provided with an anti-reflection coating 10a at the end opposite a reflecting facet 10b. The individual amplifier chips 10 are represented as fully discrete chips but may alternatively be constituted by different parts of a monolithic structure.

Each amplifier 10 is optically coupled via its anti-reflection coated facet 10a with an associated single mode optical fibre pigtail 11. The other ends of the fibre pigtails 11 are optically coupled with the N ports of an Nx1 wavelength multiplexer 12. A further length 13 of single mode optical fibre is connected to the remaining part of the multiplexer 12, and in the fibre is formed a partially reflecting Bragg reflective grating 14. The optimum reflectivity needs to be less than 100% to allow light to emerge from the optical cavity through this reflector, but the reflectivity should be high enough to dominate the feedback. The other end of the fibre 13 is connected to one input of a pump/signal wavelength-multiplexing coupler 15. Signal traffic is applied to the other input port, and the multiplexed output appears at one of its output ports, to which is connected a length 16 of optically amplifying fibre.

The Bragg reflective grating 14 co-operates, via the multiplexer 12, with the reflecting facets 10b of the semiconductor optical amplifiers 10 to form N laser cavities sharing a common optical cavity defining reflector, grating 14, in such a way as to provide a multiplexed output from the common reflector directed towards the wavelength-multiplexing coupler 15.

An example of a laser assembly composed of two lasers wavelength multiplexed by a Mach-Zehnder is depicted in Figure 2. The Mach-Zehnder 12 of the assembly of Figure 2 is constituted by a tandem arrangement of two single mode fused fibre 4-port 3dB couplers 20 and 21 coupled by two unequal lengths 22 and 23 of single mode fibre. The difference in their lengths is represented by the small loop 24.

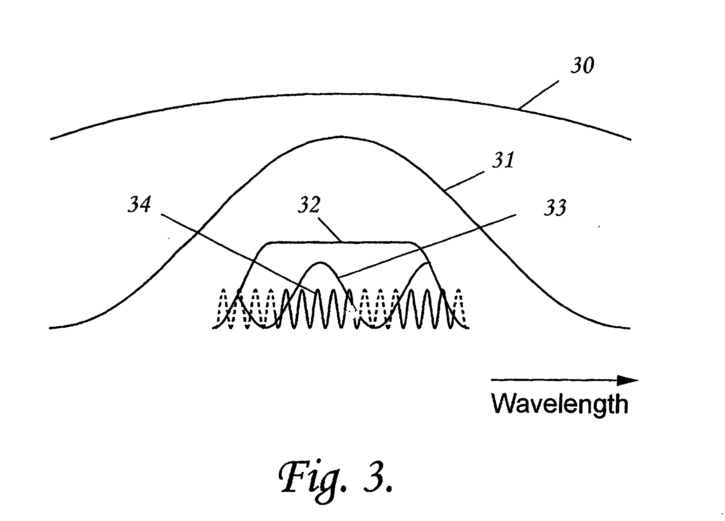

Figure 3 depicts the way the spectral characteristics of the individual components of the laser assembly of Figure 2 are nested. Curve 30 depicts the gain spectrum of the semiconductor amplifier clips 10. This is the characteristic with the widest spectral width. Next smaller is the width of the absorption characteristic 31 of the optical amplifier fibre 16.

Slightly smaller still is the spectral reflection characteristic 32 of the Bragg reflector 14. This is a non-saturating characteristic (i.e. the peak reflective coefficient is less than 100%), but it should have a relatively flat-topped reflective band with relatively fast roll-off both at the short- and long- wavelength edges of the reflective band. The Bragg reflector spectral characteristic lies entirely within the range of the absorption characteristic of the amplifier fibre 16. The absorption characteristic of the amplifier must overlap, and preferably lies entirely within, the gain spectrum 30 of the semiconductor chips 10.

The difference in optical path length between the two limbs 22 and 23 of the Mach-Zehnder is chosen to provide a substantially raised, cosine spectral characteristic 33 that includes at least one peak and at least one trough within the spectral range defined by the flat topped portion of the spectral reflective characteristic of the Bragg reflector 14. In fact the Mach-Zehnder will have two characteristics (one for the straight through path, and the other for the cross-over path) with the troughs of one registering with the crests of the other. For reasons of clarity the second characteristic has been omitted from Figure 3. Finally there will be a substantially raised cosine spectral characteristic 34 for each of the composite laser cavities that are respectively defined between the Bragg reflector 14 and the reflecting facet 10b of each of the semiconductor amplifier chips 10. To ensure that each of the N optical cavities is capable of lasing, the optical path length from each reflecting facet 10b to the Bragg reflector 14 needs to be long enough to ensure that the characteristic 34 includes several peaks and troughs within the spectral range of a single peak of the Mach-Zehnder characteristic 33. Together, those conditions ensure that there is always at least one Fabry Pérot mode inside the channel bandwidth defined by the Mach-Zehnder multiplexer, that there will be a gain peak inside the Bragg reflector bandwidth regardless of the precise value of phase imbalance provided by the Mach-Zehnder, and, provided that the Bragg reflector bandwidth is coextensive with or lies within the absorption band of the fibre amplifier, that lasing can occur at any point in the spectrum across the full bandwidth of the Bragg reflector. A further desirable design criterion is that, in order to preclude the possibility of amplifier gain modulation being produced from inter-mode beating effects the frequency spacing of the Fabry Pérot modes, as determined by the external path distance between reflecting facet 10b and Bragg grating 14, is large compared with the reciprocal of the gain time constant of the amplifier 16.

If the antireflective coatings 10a are noticeably far from ideal, then there will be another frequency dependent element in the composite cavity, this resulting from the Fabry Pérot modes as determined by the optical path length between the ends of the semiconductor amplifier chip 10. In this instance two other desiderata come into play. First the Bragg reflector bandwidth should be larger than the mode spacing of the Fabry Pérot modes of the chip in order to ensure that there is at least one Fabry Pérot mode of the chip within the spectral band of the Bragg reflector 14. Second the bandwidth of a Fabry Pérot mode of the chip must be large compared with the bandwidth of a channel defined by the multiplexer so as to ensure that there is a lasing mode at all times.

With the foregoing criteria in mind, a typical example of an assembly as depicted in Figures 1 and 2 may have semiconductor chips 10 individually emitting over a gain-providing bandwidth in excess of 20nm pumping, an erbium fibre amplifier 16 with an optical path difference providing a channel spacing of about 10 GHz, semiconductor chips of a length providing Fabry Pérot modes with a bandwidth of about 0.75nm, and an optical path distance between reflecting facets 10b and the Bragg reflector 14 providing composite cavity Fabry Pérot modes at intervals of about 40 MHz.

Light of some arbitrary wavelength emitted by semiconductor chip 10·1 into Mach-Zehnder 12 will be divided by the Mach-Zehnder into two portions, one propagating in fibre 13 and the other propagating in the unused port of the Mach-Zehnder, port 25. As the wavelength of emission is progressivly changed, the proportion launched into the unused port 25 is swept repetitively between 0 and 100%. The spectral cavity that includes semiconductor chip 10·1 will lase at a wavelength for which the round trip losses of the cavity are at a minimum. This is a wavelength for which no light from chip 10·1 is launched into the unused port 25 of the Mach-Zehnder. A similar situation holds in respect of semiconductor chip 10·2 but, since the zero power launch into unused port 25 is a straight-through condition of the Mach-Zehnder for one laser cavity and a cross-over condition for the other, it is clear that the two cavities can not lase at the same wavelength.

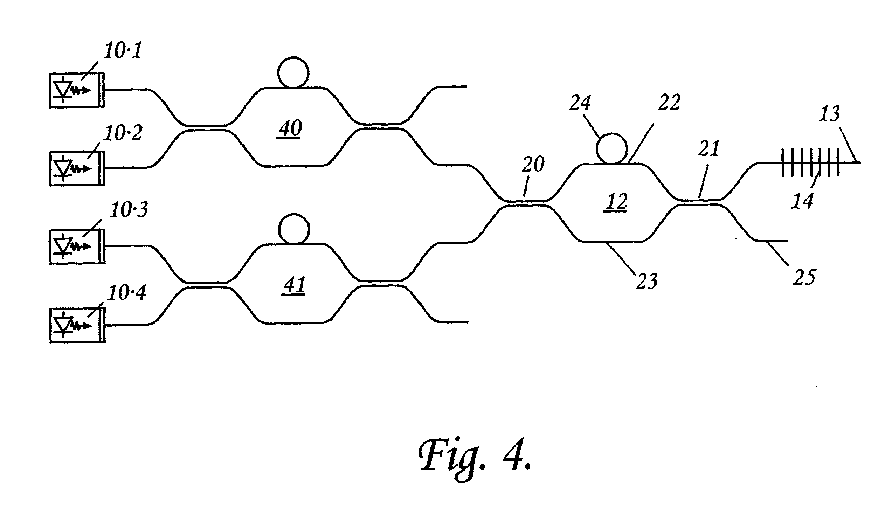

Attention is now turned to Figure 4 which schematically depicts an assembly constructed according to the same principles described above in relation to the construction of the assembly of Figure 2, the assembly of Figure 4 having an extra stage of Mach-Zehnder multiplexers. The components additional to those of the assembly of Figure 2 comprise two semiconductor optical amplifier chips 10·3, 10·4, and two further Mach-Zehnders 40, 41. The optical path difference of Mach-Zehnder 40 does not have to equal that of Mach-Zehnder 41 but, to ensure that there is a lasing frequency for each of the four chips 10·1 to 10·4 regardless of the phase difference provided by each of the three Mach-Zehnder, there should be a factor of at least two between the magnitude of the path difference of Mach-Zehnder 12 and that of each of the Mach-Zehnders 40, 41. The widest Mach-Zehnder mode spacing, as determined by the Mach-Zehnder with the smallest optical path difference, should still be smaller than the reflective bandwidth of the Bragg reflector. Similarly the narrowest Mach-Zehnder mode spacing, as determined by the Mach-Zehnder with the greatest optical path difference, should still be greater than the spacing of the Fabry Pérot modes defined between reflecting facets of the chips and the Bragg reflector so as to ensure that there is always an available lasing mode for each chip inside the wavelength range defined by that Bragg reflector.

In the case of the construction described with reference to Figure 4, the three Mach-Zehnders ensure that the four semiconductor chips 10·1 to 10·4 all lase at different wavelengths, thereby ensuring that there can be no optical interference between the four laser outputs.

## Claims

1. A laser assembly having a set of N reflectors (10b) optically coupled via a set of N optical amplifiers (10) arid an Nx1 wavelength multiplexer (12) with a partially reflecting common reflector (14) so as to define N laser cavities providing an N-way wavelength-multiplexed output from the common reflector, **characterised in that** the Nx1 wavelength multiplexer (12) comprises at least one Mach-Zehnder waveguide structure.

2. An assembly as claimed in claim 1, **characterised in that** the N optical amplifiers (10) are semiconductor optical amplifiers.

3. An optical amplifier **characterised in that** it is optically pumped by a laser assembly as claimed in claim 1 or 2.

4. An optical amplifier as claimed in claim 3, **characterised in that** the amplifier is an erbium-doped fibre amplifier.

5. A method of controlling the wavelength relationship between the emission wavelengths of a set of N lasing optical pump sources (10) in an optically pumped optical amplifier provided with feedback to make the optical pump sources lase, the method comprising providing the feedback in part by a partial reflector (14) that is common to all the lasing sources via an Nx1 wavelength multiplexing element (12) to provide a combined wavelength multiplexed optical pump output from the partial reflector, wherein the Nx1 wavelength multiplexer comprises at least one Mach-Zehnder waveguide structure.

## Patentansprüche

1. Laseranordnung mit einem Satz von N Reflektoren (10b), die optisch über einen Satz von N optischen Verstärkern (10) und einen Nx1-Wellenlängen-Multiplexer (12) mit einem teilweise reflektierenden gemeinsamen Reflektor (14) gekoppelt sind, um N Laserhohlräume zu definieren, die einen Wellenlängenmultiplexierten N-Weg-Ausgang von dem gemeinsamen Reflektor liefern, **dadurch gekennzeichnet, daß** der Nx1-Wellenlängen-Multiplexer (12) zumindest eine Mach-Zehnder-Wellenleiterstruktur umfaßt.

2. Anordnung nach Anspruch 1, **dadurch gekennzeichnet, daß** die N optischen Verstärker (10) optische Halbleiter-Verstärker sind.

3. Optischer Verstärker, **dadurch gekennzeichnet, daß** er optisch durch eine Laseranordnung nach Anspruch 1 oder 2 gepumpt wird.

4. Optischer Verstärker nach Anspruch 3, **dadurch gekennzeichnet, daß** der Verstärker ein mit Erbium dotierter Lichtleitfaser-Verstärker ist.

5. Verfahren zur Steuerung der Wellenlängen-Beziehung zwischen den Emissionswellenlängen eines Satzes von N einen Laserbetrieb aufweisenden optischen Pumpquellen (10) in einem optisch gepumpten optischen Verstärker, der mit einer Rückführung versehen ist, um einen Laserbetrieb der optischen Pumpquellen hervorzurufen, wobei das Verfahren die Bereitstellung der Rückführung teilweise durch einen Teilreflektor (14), der allen den Laserquellen gemeinsam ist, über ein Nx1-Wellenlängen-Multiplexerelement (12) umfaßt, um einen kombinierten Wellenlängen-multiplexierten optischen Pumpausgang von dem Teilreflektor zu liefern, wobei der Nx1-Wellenlängen-Multiplexer zumindest eine Mach-Zehnder-Wellenleiterstruktur umfaßt.

## Revendications

1. Dispositif laser comportant un ensemble de N réflecteurs (10b) couplés optiquement par l'intermédiaire d'un ensemble de N amplificateurs optiques (10) et d'un multiplexeur de longueurs d'onde Nx1 (12) avec un réflecteur commun (14) à réflexion partielle de manière à définir N cavités laser fournissant une sortie à multiplexage de longueurs d'onde à N voies depuis le réflecteur commun, **caractérisé en ce que** le multiplexeur de longueurs d'onde Nx1 (12) comprend au moins une structure de guide d'ondes de Mach-Zehnder.

2. Dispositif selon la revendication 1, **caractérisé en ce que** les N amplificateurs (10) sont des amplificateurs optiques à semiconducteurs.

3. Amplificateur optique, **caractérisé en ce qu'**il est pompé optiquement par un dispositif laser selon la revendication 1 ou 2.

4. Amplificateur optique selon la revendication 3, **caractérisé en ce que** l'amplificateur est un amplificateur à fibre dopé à l'erbium.

5. Procédé pour commander la relation entre les longueurs d'onde d'émission d'un ensemble de N sources de pompage optique à effet laser (10) dans un amplificateur optique pompé optiquement pourvu d'une réaction pour faire produire l'effet laser par les sources de pompage optique, le procédé comprenant l'étape consistant à procurer la réaction en partie au moyen d'un réflecteur partiel (14) qui est commun à l'ensemble des sources à effet laser par l'intermédiaire d'un élément de multiplexage de longueurs d'onde Nx1 (12) pour fournir une sortie de pompage optique combinée à multiplexage de longueurs d'onde depuis le réflecteur partiel, le multiplexeur de longueurs d'onde Nx1 comprenant au moins une structure de guide d'ondes de Mach-Zehnder.
